# EUROPEAN PATENT SPECIFICATION

(11) **EP 3 484 003 B1**
(45) Date of publication and mention of the grant of the patent: **30.11.2022**
(21) Application number: 17201084.5
(22) Date of filing: 10.11.2017
(51) Int. Cl.: H02H 11/00, H02M 1/32, H03K 17/082

(54) **CIRCUIT ARRANGEMENT FOR AN ELECTRIC POWER CONVERTER, ELECTRIC POWER CONVERTER FOR A VEHICLE AND VEHICLE**
SCHALTUNGSANORDNUNG FÜR EINEN STROMWANDLER, STROMWANDLER FÜR EIN FAHRZEUG UND FAHRZEUG
AGENCEMENT DE CIRCUIT POUR UN CONVERTISSEUR DE PUISSANCE ÉLECTRIQUE, CONVERTISSEUR DE PUISSANCE ÉLECTRIQUE POUR UN VÉHICULE ET VÉHICULE

(43) Date of publication of application: 15.05.2019
(73) Proprietor: Valeo eAutomotive Germany GmbH, 91056 Erlangen (DE)
(72) Inventor: BAUMANN, Mathias, 08056 Zwickau (DE)
(74) Representative: Valeo Powertrain Systems

(56) References cited:
- US-A1- 2007 268 048
- US-A1- 2015 326 002
- US-B2- 8 810 144

## Description

The present invention relates to a circuit arrangement for electric power converters according to claims 1 and 2.

Aside, the invention relates to an electric power converter for a vehicle and a vehicle.

Circuit arrangements comprising a switching element realized by an insulated gate field-effect transistor (IGFET) are commonly used for connecting a load connected a source terminal to a DC voltage source and disconnecting the load from the DC voltage source depending on a voltage applied to a gate terminal. Therefore, the DC voltage source is connected to a first and second connector of the second arrangement. However, if the DC voltage source is connected with a wrong polarity to the connectors, the transistor may connect the load to the DC voltage source even if the voltage is zero because of a body diode of the transistor being in forward operation. This may cause a short circuit and may result in a damage of the switching element due to a negative temperature coefficient of the body diode. In order to avoid a damage of the switching element in the case of a wrong polarity on the DC voltage source, it has been proposed to use an insulated gate bipolar transistor (IGBT) instead of the IGFET. Nevertheless, for some applications the usage of an IGFET is preferred due to useful properties. Alternatively, a diode being in reverse direction when the DC voltage source is connected with the wrong polarity can be looped into a path of the short-circuit. This solution suffers from a voltage drop over the diode when the DC voltage source is connected with the correct polarity. Furthermore, the usage of transient-voltage-suppression diodes in combination with a fuse has been proposed. However, the fuse has to be replaced after the DC voltage source has been connected with the wrong polarity. Finally, active polarity protection devices are known, which suffer from requiring an external power supply.

US 2007/268048, US 2015/326002 and US8810144 B2 disclose a switching element being realized by at least one insulated gate field effect transistor having a body diode, a diode connected from the second terminal to the source terminal of the switch.

Thus, it is an object of the invention to provide a circuit arrangement with an improved polarity protection.

The above object is solved by a circuit arrangement as initially described, comprising a diode connected from the second terminal to the gate terminal in a direction corresponding to a direction of the body diode from the source terminal to the drain terminal.

The invention is based upon the consideration to configure the circuit arrangement such that in the case of the DC voltage source being connected with a wrong polarity to the first and second connector a voltage supplied by the DC voltage source is applied to the gate terminal via the diode being in forward direction. By applying the voltage to the gate terminal an operation characteristic of the transistor being in a reverse mode does not correspond to the operation characteristic of the body diode as a channel of the transistor is conducting. Therein, the power loss of the switching element is significantly reduced in comparison to the operation characteristic corresponding to the body diode being in forward direction.

Advantageously, the switching element realized by the IGFET is effectively protected from being damaged when the DC voltage source is connected with the wrong polarity. Particularly, the circuit arrangement according to the invention does not require an external power supply but works completely passively. Additionally, fuses and a voltage drop over a diode being connected in series with the switching element and the load are avoided.

If the transistor has an n-channel, the body diode is in forward direction from the source terminal to the drain terminal. Then the diode is connected from the second connector to the gate terminal in forward direction. Preferably, the pole of the DC source connected or connectable to the first connector is a positive pole and/or the inverse pole of the DC source is a negative pole. The switching element may be interconnected as a high-side switch.

If the transistor has a p-channel, the body diode is in reverse direction from the source terminal to the drain terminal. Then the diode is connected from the second connector to the gate terminal in reverse direction. Preferably, the pole of the DC source connected or connectable to the first connector is a negative pole and/or the inverse pole of the DC source is a positive pole. The switching element may be interconnected as a low-side switch.

Typically, the transistor is a metal insulator semiconductor field-effect transistor (MISFET), particularly a metal oxide semiconductor field-effect transistor (MOSFET). The denomination of the terminals of the switching element corresponds to the denomination of respective transistor terminals froming the terminals of the switching element. The circuit arrangement may comprise a third connector, to which the load is connected or connectable. Particularly, the third connector and the source terminal have a common potential and/or the diode and the gate terminal have a common potential and/or the first connector and the drain terminal have a common potential.

It is preferred that the diode has a significantly low forward voltage. Therefore, the diode may be Schottky diode or a germanium diode.

Furthermore, the switching element of the circuit arrangement according to the invention may be realized by at least one further insulated gate field-effect transistor, wherein the transistors are connected in parallel. This means that the transistor terminals each have a common potential with the equally denominated terminal of the switching element. Using a plurality of transistors allows of the switching elements to conduct a higher current. When connecting a DC source with a wrong polarity to a conventional circuit arrangement with a plurality of insulated gate field-effect transistors being connected in parallel, due to random production tolerances only one of the transistors is operated with the operation characteristic of the body diode until the transistor is damaged. Afterward the other transistors will be damaged cascade-like. Advantageously, the circuit arrangement allows balanced parallel currents through the transistors.

Aside, the circuit arrangement according to the invention may comprise a capacitor connected between a gate-side terminal of the diode and the source terminal. The capacitor is loaded when the DC voltage source is connected to the first and the second terminal with the wrong polarity and buffers the voltage supplied by the DC voltage source, advantageously.

The circuit arrangement may further comprise a second diode connected from the first diode and the capacitor to the gate terminal in a direction corresponding to the direction of the body diode. The first diode, the second diode and the capacitor may have a common potential. Advantageously, the second diode avoids that the capacitor is connected in parallel to a gate capacitance of the transistor when the DC voltage source is connected with the correct polarity. The second diode may be Schottky diode or a germanium diode.

For allowing a discharge of a gate capacitance it is preferred that the circuit arrangement according to the invention may comprise a discharge resistor connected between the gate terminal and the source terminal. The discharge resistor may have a common potential with a gate terminal and/or a common potential with the source terminal and/or a common potential with a terminal of the capacitor being not connected to the first diode.

Preferably, a time constant being a product of the resistance of the discharge resistor and the capacitance of the capacitor is chosen such that a gate-source-voltage of the switching element is above a threshold voltage of the switching element for a predefined time span. Note that the switching element may remain conductive after this time span since its gate terminal is still controlled by the DC voltage source being connected with the wrong polarity.

Aside, the invention relates to an electric power converter for a vehicle, comprising the circuit arrangement according to the invention, wherein the load is a power unit of the electric power converter. The electric power converter is preferably a DC/DC converter.

Furthermore, the invention relates to a vehicle, comprising an electric system, a DC voltage source and the electric power converter according to the invention configured to supply a voltage to the electric system.

The electric power converter and/or the vehicle may comprise the control unit being connected to the fourth connector and being configured to provide the control voltage to the gate terminal for connecting the DC voltage source to the power unit and for disconnecting the DC voltage source from the power unit.

All statements referring to the inventive inverter apply analogously to the inventive electric machine and the inventive vehicle, so that the above-mentioned advantages of the inventive inverter may be achieved as well.

Further details and advantages of the invention are disclosed in the following, wherein reference is made to the schematic drawings showing:
Fig. 1 a diagram of a first embodiment of the circuit arrangement according to the invention;
Fig. 2 a diagram of progresses of voltages of the circuit arrangement depicted in Fig. 1 over time;
Fig. 3 a diagram of a second embodiment of the circuit arrangement according to the invention;
Fig. 4 a diagram of progresses of voltages of the circuit arrangement depicted in Fig. 3 over time;
Fig. 5 a diagram of a switching element of a third embodiment of the circuit arrangement according to the invention;
Fig. 6 a block diagram of a fourth embodiment of the circuit arrangement according to the invention;
Fig. 7 a block diagram of an embodiment of an electric power converter according to the invention;
Fig. 8 a block diagram of an embodiment of a vehicle according to the invention.

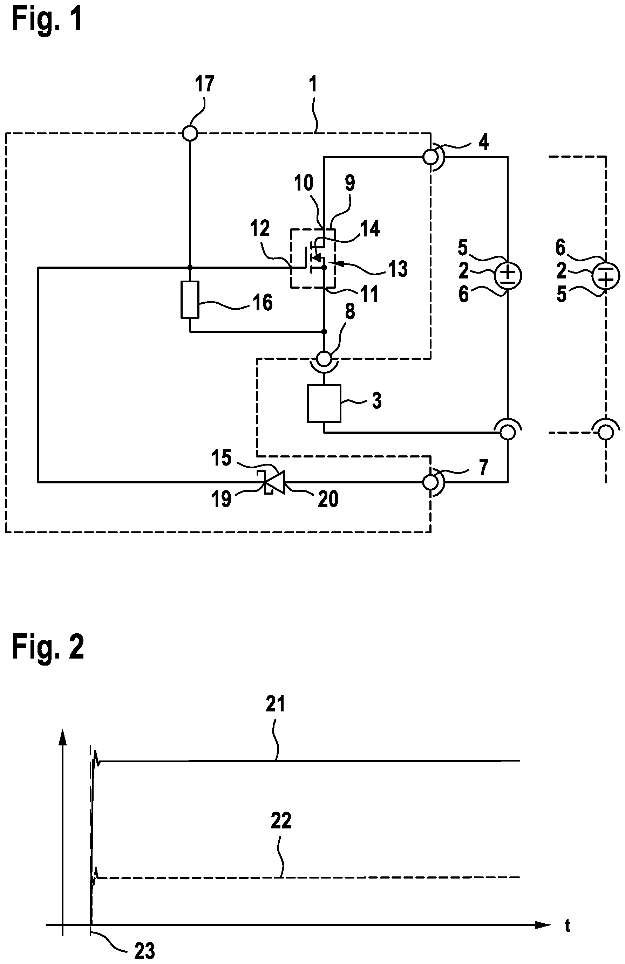

Fig. 1 is a diagram of a first embodiment of a circuit arrangement 1, a DC voltage source 2 and a load 3 supplied by the DC voltage source 2. In Fig. 1 solid lines emanating from the DC voltage source 2 represent a connection to the circuit arrangement 1 with a correct polarity and corresponding dashed lines represent a connection to the circuit arrangement 1 with a wrong polarity.

The circuit arrangement 1 comprises a first connector 4 connected to a positive pole 5 of the DC voltage source 2 in the case of the correct polarity and connected to a negative pole 6 of the DC voltage source 2 in the case of the wrong polarity.

Correspondingly, the second connector 7 of the circuit arrangement 1 is connected to the negative pole 6 in the case of the right polarity and connected to the positive pole 6 in the case of the wrong polarity. Aside, a third connector 8 is provided for connecting the load 3 to the circuit arrangement 1.

Furthermore, the circuit arrangement 1 comprises a switching element 9 having a drain terminal 10 connected to the first connector 4, a source terminal 11 connected to the load 3 via the third connector 8 and a gate terminal 12. The switching element 9 is realized by an n-channel insulated gate field-effect transistor 13 (IGFET) having a body diode 14 being in forward direction from the source terminal 11 to the drain terminal 10. Consequently, the switching element 9 works as a high-side switch with respect to the right polarity of the DC voltage source 2.

Moreover, the second arrangement 1 comprises a diode 15 formed by a Schottky diode or a germanium diode connected in forward direction from the second terminal 7 to the gate terminal 12. Thus, the direction of the diode 15 from the second terminal 7 to the gate terminal 12 corresponds to the direction of the body diode 14 from the source terminal 11 to the drain terminal 10.

Additionally, a high-ohmic discharging resistor 16 is connected between the gate terminal 12 and the source terminal 11, allowing a faster discharge of a gate capacitance. Finally, a fourth connector 17 connected to the gate terminal 12, a cathode 19 of the diode 15 and the discharging resistor 16 is provided for controlling the switching state of the switching element 9 by applying a positive voltage to the gate terminal 12.

In the case of the DC voltage source 2 being connected with the right polarity as depicted by the solid lines an anode 20 of the diode 15 is connected to the negative pole 6 of the DC voltage source 2 via the second connector 7. The diode 15 is thus operated in a reverse operation mode and blocking. By applying the voltage to the gate terminal 12 via the fourth connector 17 the switching element 9 may be switched between a blocking switching state in a cut-off operation region of the transistor 13 and a conducting switching state in a linear or a saturated operation region of the transistor 13. In the conducting switching state current supplied by the DC voltage source to flows through the load 3, whereas in the blocking switching state substantially no current flows through the load 3.

However, it has to be assumed that the DC voltage source 2 is connected with the wrong polarity to the first connector 4 on the one hand and to the second connector 7 and the load 3 on the other hand. This might e.g. happen due to mounting failures or an accidental misconnection by a human being. In this case depicted by the dashed lines the anode 20 is connected to the positive pole 5 of the DC voltage source 2 via the second connector 7. Thus, the diode 15 is operated in a forward operation mode, wherein a positive voltage from the positive pole 5 is applied to the gate terminal 12. Although the body diode 14 is connected to the DC voltage source 2 in forward direction, the voltage applied to the gate terminal 12 causes the transistor 13 to be operated in an inverse operation region. Thus, it is avoided that the current from the third terminal 8 to the first terminal 4 is conducted by the body diode 14. Instead the positive voltage of the DC voltage source 2 supplied to the gate terminal 12 via the conducting diode 15 allows the current 2 flow through the channel of the transistor 13. Advantageously, a damage of the transistor 13 is avoided, which would be caused by a negative temperature coefficient of the body diode 14 if the diode 15 was omitted.

Fig. 2 is a diagram of progresses of a negative voltage 21 supplied by the DC voltage source 2 and a gate-source-voltage 22 over time t in the case of the DC voltage source 2 being connected with the wrong polarity. As can be seen, at a time 23, at which the DC voltage source 2 is connected to the first connector 4 and the second connector 7, the voltage 21 rises and has a negative value of e.g. 9.2 V in a stationary state. Consecutively, the gate-source-voltage 22 rises and has a voltage of e.g. 2.5 V in a stationary state, wherein this voltage is sufficient to avoid substantially the current flow through the body diode 14.

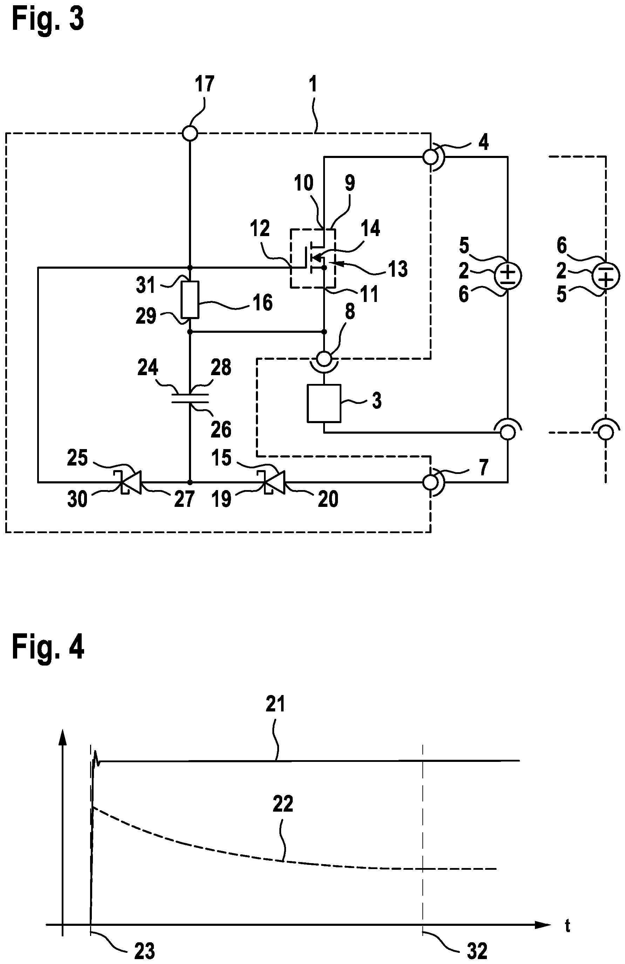

Fig. 3 is a diagram of the second embodiment of a circuit arrangement 1 corresponding to the first embodiment, wherein a capacitor 24 connected between a gate-side terminal of the first diode 15 and the source terminal 11 and a second diode 25 connected from the first diode 15 to the gate terminal 12 are provided additionally.

The capacitor 24 has a first terminal 26, which has a common potential with the cathode 19 being the gate-side terminal of the first diode 15 and with an anode 27 of the second diode 25. A second terminal 28 of the capacitor 24 has a common potential with the source terminal 11 and with a first terminal 29 of the discharging resistor 16. A cathode 30 of the second diode 25 has a common potential with the gate terminal 12, a second terminal 31 of the discharging resistor 16 and the fourth connector 17. The capacitor 24 buffers the voltage of the DC voltage source 2 when being connected with the wrong polarity, wherein the second diode 25 avoids that the transistor 24 is connected in parallel to the gate capacity of the transistor 13 in the case of the DC voltage source 2 being connected with the correct polarity.

Fig. 4 is a diagram of progresses of a negative voltage 21 supplied by the DC voltage source 2 and a gate-source-voltage 22 over time t in the case of the DC voltage source 2 being connected with the wrong polarity. As can be seen, at a time 23, at which the DC voltage source 2 is connected to the first connector 4 and the second connector 7, the voltage 21 rises and has a negative value of e.g. 9.2 V in a stationary state. Consecutively, the gate-source-voltage 22 rises to a higher level of e.g. 6.8 V and falls to a constant level of e.g. 2.5 V at a time 32 because of the capacitor 24 being loaded. By choosing the resistance of the discharging resistor 16 and the capacity of the capacitor 24 to a time constant being the product from the resistance and the capacity it is achieved that the gate-source-voltage is surely above a threshold voltage of the transistor 13 for a predefined, critical time span. In the configuration resulting in the progresses depicted in Fig. 4, the capacity is 30 µF and the resistance is 47.5 kΩ, resulting in a time coefficient of 1.425 s.

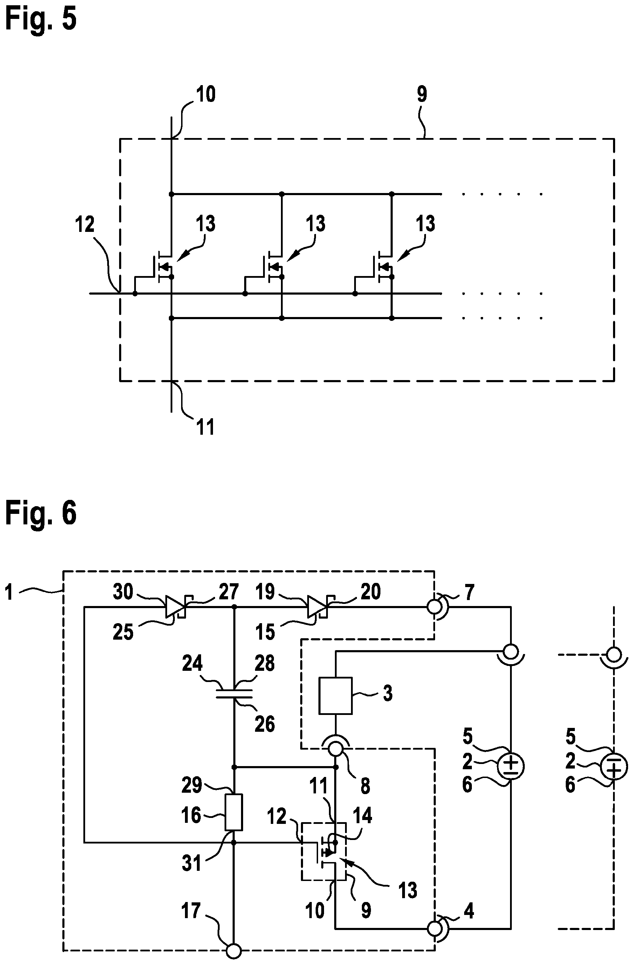

Fig. 5 is a diagram of a switching element 9 of a third embodiment of a circuit arrangement corresponding to the above-mentioned ones, wherein the switching element 9 is realized by a plurality of transistors 13 connected in parallel. Therein, the drain terminals of the transistors 13 have a common potential with the drain terminal 10 of the switching element 9, the source terminals of the transistors 13 have a common potential with the source terminal 11 of the switching element 9 and the gate terminals of the transistors 13 have a common potential with the gate terminal 12 of the switching element 9. Typically, six, eight or more transistors 13 are connected in parallel.

Fig. 6 is a diagram of a fourth embodiment of a circuit arrangement 1 corresponding to the second embodiment depicted in fig. 3, wherein the switching element 9 is realized by a p-channel insulated gate field-effect transistor 13.

In this case the switching element 9 works as a low-side switch. In contrast to fig. 3, the DC voltage source 2 is connected with the correct polarity when the positive pole 5 is connected to the second connector 7 and the negative pole 6 is connected to the first connector 4 and vice versa in the case of the wrong polarity. As the body diode 14 of the transistor 13 is in opposite direction to the body diode of an n-channel transistor, the cathode 19 of the first diode 15 is connected to the second connector 7 and the cathode 30 of the second diode 25 is connected to the anode 20 of the first diode 15. Thus, the anode 20, the cathode 30 and the first terminal of the capacitor 24 have a common potential and the gate terminal 12, the anode 27, the second terminal 31 of the discharging resistor 16 and the fourth connector 17 have a common potential.

According to a fifth embodiment of the circuit arrangement 1 corresponding to the fourth embodiment depicted in Fig. 6, the capacitor 24 and the second diode 25 are omitted, so that this embodiment is similar to the first embodiment depicted in Fig. 1, wherein the switching element 9 works as a low-side switch realized by the p-channel transistor 13.

According to a sixth embodiment of a circuit arrangement 1 corresponding to the fourth or fifth embodiment, the switching element 9 is realized by a plurality of p-channel transistors 13 similar to Fig. 5.

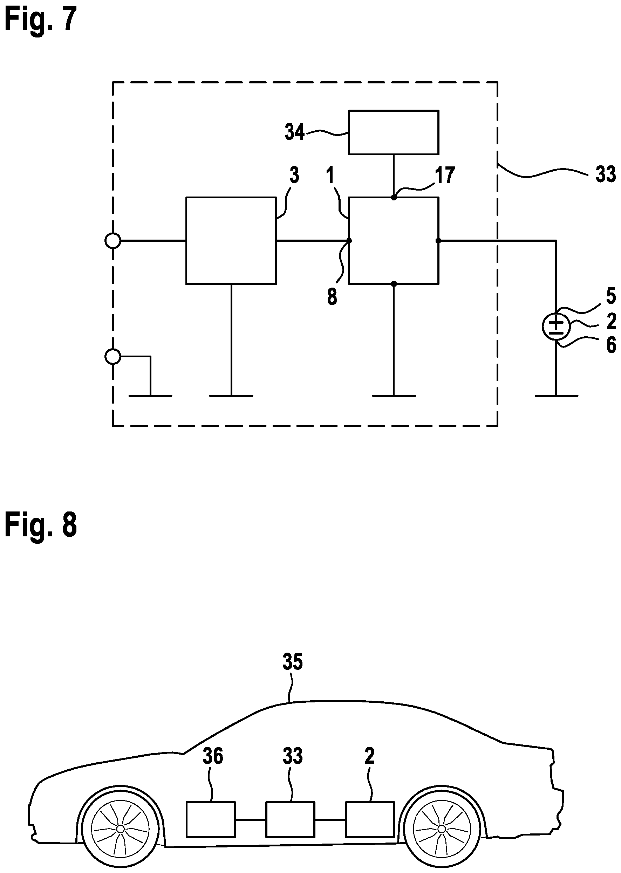

Fig. 7 is a block diagram of an electric power converter 33 and a DC voltage source 2. The electric power converter 33 comprises a circuit arrangement 1 corresponding to one of the afore-mentioned embodiments, a load 3 and a control unit 34. The load 3 is a power unit that allows the electric power converter 33 to be operated as a DC/DC-converter.

The load 3 is connected to the third connector 8 and the control unit 34 is connected to the fourth connector 17 of the circuit arrangement 1. Thus, the control unit 34 allows to control the switching element 9 to connect the load 3 to or disconnect the load 3 from the DC voltage source 2.

In the case of the switching element 9 being realized by one or more n-channel transistors 13 the DC voltage source 2 has its right polarity when the positive pole 5 is connected to the first connector 4 and the negative pole 6 is connected to second connector 7. In the case of the switching element 9 being realized by one or more p-channel transistors 13 the DC voltage source 2 has its correct polarity when the positive pole 5 is connected to the second connector 7 and the negative pole 6 is connected to the first connector 4.

Fig. 8 is a block diagram of a vehicle 35 comprising an electric system 36, a DC voltage source 2 and an electric power converter 33 corresponding to the afore-mentioned embodiment configured to supply a voltage to the electric system 36.

## Claims

1. Circuit arrangement (1) for an electric power converter (33), comprising:
- a first connector (4) connectable to a pole (5, 6) of a DC voltage source (2),
- a second connector (7) connectable to an inverse pole (5, 6) of the DC voltage source (2),
- a switching element (9) having
(i) a drain terminal (10) connected to the first connector (4),
(ii) a source terminal (11) connectable to a load (3) and
(iii) a gate terminal (12)
and being realized by at least one insulated gate field effect transistor (13) having a body diode (14) being in forward direction from the source terminal (11) to the drain terminal (10) and
- a diode (15) connected from the second connector (7) to the gate terminal (12) in forward direction
**characterized by**
a further connector (17) connected to the gate terminal (12) and configured to obtain a control voltage to switch the switching element (9) when being operated in a forward mode.

2. Circuit arrangement (1) for an electric power converter (33), comprising:
- a first connector (4) connectable to a pole (5, 6) of a DC voltage source (2),
- a second connector (7) connectable to an inverse pole (5, 6) of the DC voltage source (2),
- a switching element (9) having
(i) a drain terminal (10) connected to the first connector (4),
(ii) a source terminal (11) connectable to a load (3) and
(iii) a gate terminal (12)
and being realized by at least one insulated gate field effect transistor (13) having a body diode (14) and
- a diode (15)
**characterized in that**
the body diode (14) is in reverse direction from the source terminal (11) to the drain terminal (10) and the diode (15) is connected from the second connector (7) to the gate terminal (12) in reverse direction, wherein
the circuit arrangement (1) further comprises a further connector (17) connected to the gate terminal (12) and configured to obtain a control voltage to switch the switching element (9) when being operated in a forward mode.

3. Circuit arrangement according to claim 1 or 2, **characterized in that** the diode (15) is a Schottky diode or a germanium diode.

4. Circuit arrangement according to any of the preceding claims, **characterized in that** the switching element (9) is realized by at least one further insulated gate field-effect transistor (13), wherein the transistors (13) are connected in parallel.

5. Circuit arrangement according to any of the preceding claims, **characterized in that** it comprises a capacitor (24) connected between a gate-side terminal of the diode (15) and the source terminal (11).

6. Circuit arrangement according to claim 5, when being dependent on claim 1, **characterized in that** it comprises a second diode (25) connected from the first diode (15) to the gate terminal (12) in forward direction.

7. Circuit arrangement according to claim 5, when being dependent on claim 2, **characterized in that** it comprises a second diode (25) connected form the first diode (15) to the gate terminal (12) in reverse direction.

8. Circuit arrangement according to any of the preceding claims, **characterized in that** it comprises a discharge resistor (16) connected between the gate terminal (12) and the source terminal (11).

9. Circuit arrangement according to claim 8, when being dependent on claim 5, **characterized in that** a time constant being a product of the resistance of the discharge resistor (16) and the capacitance of the capacitor (24) is chosen such that a gate-source-voltage of the switching element (9) is above a threshold voltage of the switching element (9) for a predefined time span.

10. Electric power converter (33) for a vehicle (35), comprising a circuit arrangement (1) according to any of claims 1 to 9, wherein the load (3) is a power unit of the electric power converter (33).

11. Electric power converter according to claim 10, **characterized in that** it is a DC/DC-converter.

12. Electric power converter according to claim 10 or 11, further comprising a control unit (34) being connected to the further connector (17) and being configured to provide the control voltage to the gate terminal (12) for connecting the DC voltage source (2) to the power unit and for disconnecting the DC voltage source (2) from the power unit.

13. Vehicle (35), comprising an electric system (36), a DC voltage source (2) and an electric power converter (33) according to any of claims 10 to 12 configured to supply a voltage to the electric system (36).

14. Vehicle according to claim 13, further comprising a control unit being connected to the further connector (17) and being configured to provide the control voltage to the gate terminal (12) for connecting the DC voltage source (2) to the power unit and for disconnecting the DC voltage source (2) from the power unit.

## Patentansprüche

1. Schaltungsanordnung (1) für einen elektrischen Stromrichter (33), Folgendes umfassend:
- einen ersten Verbinder (4), der mit einem Pol (5, 6) einer Gleichspannungsquelle (2) verbunden werden kann,
- einen zweiten Verbinder (7), der mit einem Gegenpol (5, 6) der Gleichspannungsquelle (2) verbunden werden kann,
- ein Schaltelement (9), das Folgendes aufweist:
(i) einen Drain-Anschluss (10), der mit dem ersten Verbinder (4) verbunden ist,
(ii) einen Source-Anschluss (11), der mit einer Last (3) verbunden werden kann, und
(iii)einen Gate-Anschluss (12)
und durch mindestens einen Feldeffekttransistor (13) mit isoliertem Gate realisiert ist, der eine Body-Diode (14) aufweist, die sich in Vorwärtsrichtung vom Source-Anschluss (11) zum Drain-Anschluss (10) befindet und
- eine Diode (15), die vom zweiten Verbinder (7) mit dem Gate-Anschluss (12) in Vorwärtsrichtung verbunden ist,
**gekennzeichnet durch**
einen weiteren Verbinder (17), der mit dem Gate-Anschluss (12) verbunden und so ausgebildet ist, dass er eine Steuerspannung erhält, um das Schaltelement (9) zu schalten, wenn es in einem Vorwärtsmodus betrieben wird.

2. Schaltungsanordnung (1) für einen elektrischen Stromrichter (33), Folgendes umfassend:
- einen ersten Verbinder (4), der mit einem Pol (5, 6) einer Gleichspannungsquelle (2) verbunden werden kann,
- einen zweiten Verbinder (7), der mit einem Gegenpol (5, 6) der Gleichspannungsquelle (2) verbunden werden kann,
- ein Schaltelement (9), das Folgendes aufweist:
(i) einen Drain-Anschluss (10), der mit dem ersten Verbinder (4) verbunden ist,
(ii) einen Source-Anschluss (11), der mit einer Last (3) verbunden werden kann, und
(iii)einen Gate-Anschluss (12)
und durch mindestens einen Isolierschicht-Feldeffekttransistor (13) realisiert wird, der eine Body-Diode (14) aufweist, und
- eine Diode (15)
**dadurch gekennzeichnet, dass**
die Body-Diode (14) in umgekehrter Richtung vom Source-Anschluss (11) zum Drain-Anschluss (10) und die Diode (15) in umgekehrter Richtung vom zweiten Verbinder (7) zum Gate-Anschluss (12) verbunden ist,
wobei die Schaltungsanordnung (1) ferner einen weiteren Verbinder (17) umfasst, der mit dem Gate-Anschluss (12) verbunden und so ausgebildet ist, dass er eine Steuerspannung erhält, um das Schaltelement (9) zu schalten, wenn es in einem Vorwärtsmodus betrieben wird.

3. Schaltungsanordnung gemäß Anspruch 1 oder 2, **dadurch gekennzeichnet, dass** die Diode (15) eine Schottky-Diode oder eine Germanium-Diode ist.

4. Schaltungsanordnung gemäß einem der vorhergehenden Ansprüche, **dadurch gekennzeichnet, dass** das Schaltelement (9) durch mindestens einen weiteren Isolierschicht-Feldeffekttransistor (13) realisiert ist, wobei die Transistoren (13) parallel geschaltet sind.

5. Schaltungsanordnung gemäß einem der vorhergehenden Ansprüche, **dadurch gekennzeichnet, dass** sie einen Kondensator (24) umfasst, der zwischen einem gateseitigen Anschluss der Diode (15) und dem Source-Anschluss (11) angeschlossen ist.

6. Schaltungsanordnung gemäß Anspruch 5, in Abhängigkeit von Anspruch 1, **dadurch gekennzeichnet, dass** sie eine zweite Diode (25) umfasst, die von der ersten Diode (15) mit dem Gate-Anschluss (12) in Vorwärtsrichtung verbunden ist.

7. Schaltungsanordnung gemäß Anspruch 5, in Abhängigkeit von Anspruch 2, **dadurch gekennzeichnet, dass** sie eine zweite Diode (25) umfasst, die von der ersten Diode (15) in umgekehrter Richtung mit dem Gate-Anschluss (12) verbunden ist.

8. Schaltungsanordnung gemäß einem der vorhergehenden Ansprüche, **dadurch gekennzeichnet, dass** sie einen Entladewiderstand (16) umfasst, der zwischen dem Gate-Anschluss (12) und dem Source-Anschluss (11) angeschlossen ist.

9. Schaltungsanordnung gemäß Anspruch 8, in Abhängigkeit von Anspruch 5, **dadurch gekennzeichnet, dass** eine Zeitkonstante, die ein Produkt aus dem Widerstand des Entladewiderstands (16) und der Kapazität des Kondensators (24) ist, so gewählt ist, dass eine Gate-Source-Spannung des Schaltelements (9) für eine vorgegebene Zeitspanne oberhalb einer Schwellenspannung des Schaltelements (9) liegt.

10. Elektrischer Stromrichter (33) für ein Fahrzeug (35), mit einer Schaltungsanordnung (1) gemäß einem der Ansprüche 1 bis 9, wobei die Last (3) ein Leistungsteil des elektrischen Stromrichters (33) ist.

11. Elektrischer Stromrichter gemäß Anspruch 10, **dadurch gekennzeichnet, dass** er ein DC/DC-Wandler ist.

12. Elektrischer Stromrichter gemäß Anspruch 10 oder 11, der ferner eine Steuereinheit (34) umfasst, die mit dem weiteren Verbinder (17) verbunden und so ausgebildet ist, dass sie die Steuerspannung an den Gate-Anschluss (12) liefert, um die Gleichspannungsquelle (2) mit der Leistungseinheit zu verbinden und die Gleichspannungsquelle (2) von der Leistungseinheit zu trennen.

13. Fahrzeug (35), das ein elektrisches System (36), eine Gleichspannungsquelle (2) und einen elektrischen Stromrichter (33) gemäß einem der Ansprüche 10 bis 12 umfasst, der so ausgebildet ist, dass er dem elektrischen System (36) eine Spannung zuführt.

14. Fahrzeug gemäß Anspruch 13, das ferner eine Steuereinheit umfasst, die mit dem weiteren Verbinder (17) verbunden und so ausgebildet ist, dass sie die Steuerspannung an den Gate-Anschluss (12) liefert, um die Gleichspannungsquelle (2) mit der Leistungseinheit zu verbinden und die Gleichspannungsquelle (2) von der Leistungseinheit zu trennen.

## Revendications

1. Agencement de circuit (1) pour un convertisseur de puissance électrique (33), comprenant :
- un premier connecteur (4) pouvant être connecté à un pôle (5, 6) d'une source de tension continue (2),
- un second connecteur (7) pouvant être connecté à un pôle inverse (5, 6) de la source de tension continue (2),
- un élément de commutation (9) comportant
(i) une borne de drain (10) connectée au premier connecteur (4),
(ii) une borne de source (11) pouvant être connectée à une charge (3) et
(iii) une borne de grille (12)
et qui est constitué par au moins un transistor à effet de champ à grille isolée (13) comportant une diode de corps (14) se trouvant dans le sens direct, de la borne de source (11) à la borne de drain (10) et
- une diode (15) connectée du second connecteur (7) à la borne de grille (12) en sens direct,
**caractérisé par**
un autre connecteur (17) connecté à la borne de grille (12) et configuré pour obtenir une tension de commande afin de commuter l'élément de commutation (9) lorsqu'il fonctionne dans un mode direct.

2. Agencement de circuit (1) pour un convertisseur de puissance électrique (33), comprenant :
- un premier connecteur (4) pouvant être connecté à un pôle (5, 6) d'une source de tension continue (2),
- un second connecteur (7) pouvant être connecté à un pôle inverse (5, 6) de la source de tension continue (2),
- un élément de commutation (9) comportant
(i) une borne de drain (10) connectée au premier connecteur (4),
(ii) une borne de source (11) pouvant être connectée à une charge (3) et
(iii) une borne de grille (12)
et qui est constituée par au moins un transistor à effet de champ à grille isolée (13) comportant une diode de corps (14) et
- une diode (15),
**caractérisé en ce que**
la diode de corps (14) est en sens inverse, de la borne de source (11) à la borne de drain (10), et la diode (15) est connectée du second connecteur (7) à la borne de grille (12) en sens inverse, dans lequel l'agencement de circuit (1) comprend en outre un autre connecteur (17) connecté à la borne de grille (12) et configuré pour obtenir une tension de commande afin de commuter l'élément de commutation (9) lorsqu'il fonctionne dans un mode direct.

3. Agencement de circuit selon la revendication 1 ou 2, **caractérisé en ce que** la diode (15) est une diode Schottky ou une diode au germanium.

4. Agencement de circuit selon l'une quelconque des revendications précédentes, **caractérisé en ce que** l'élément de commutation (9) est constitué par au moins un autre transistor à effet de champ à grille isolée (13), dans lequel les transistors (13) sont connectés en parallèle.

5. Agencement de circuit selon l'une quelconque des revendications précédentes, **caractérisé en ce qu'**il comprend un condensateur (24) connecté entre une borne côté grille de la diode (15) et la borne de source (11).

6. Agencement de circuit selon la revendication 5, lorsqu'elle dépend de la revendication 1, **caractérisé en ce qu'**il comprend une seconde diode (25) connectée de la première diode (15) à la borne de grille (12) en sens direct.

7. Agencement de circuit selon la revendication 5, lorsqu'elle dépend de la revendication 2, **caractérisé en ce qu'**il comprend une seconde diode (25) connectée de la première diode (15) à la borne de grille (12) en sens inverse.

8. Agencement de circuit selon l'une quelconque des revendications précédentes, **caractérisé en ce qu'**il comprend une résistance de décharge (16) connectée entre la borne de grille (12) et la borne de source (11).

9. Agencement de circuit selon la revendication 8, lorsqu'elle dépend de la revendication 5, **caractérisé en ce que** l'on choisit une constante de temps qui est un produit de la valeur de la résistance de décharge (16) par la capacité du condensateur (24) de telle sorte qu'une tension grille-source de l'élément de commutation (9) soit supérieure à une tension de seuil de l'élément de commutation (9) pendant un intervalle de temps prédéfini.

10. Convertisseur de puissance électrique (33) pour un véhicule (35), comprenant un agencement de circuit (1) selon l'une quelconque des revendications 1 à 9, dans lequel la charge (3) est une unité d'alimentation du convertisseur de puissance électrique (33).

11. Convertisseur de puissance électrique selon la revendication 10, **caractérisé en ce qu'**il s'agit d'un convertisseur continu/continu.

12. Convertisseur de puissance électrique selon la revendication 10 ou 11, comprenant en outre une unité de commande (34) qui est connectée à l'autre connecteur (17) et qui est configurée pour fournir la tension de commande à la borne de grille (12) afin de connecter la source de tension continue (2) à l'unité d'alimentation et de déconnecter la source de tension continue (2) de l'unité de d'alimentation.

13. Véhicule (35), comprenant un système électrique (36), une source de tension continue (2) et un convertisseur de puissance électrique (33) selon l'une quelconque des revendications 10 à 12 configuré pour fournir une tension au système électrique (36).

14. Véhicule selon la revendication 13, comprenant en outre une unité de commande connectée à l'autre connecteur (17) et configurée pour fournir la tension de commande à la borne de grille (12) afin de connecter la source de tension continue (2) à l'unité d'alimentation et de déconnecter la source de tension continue (2) de l'unité d'alimentation.
